# EUROPEAN PATENT APPLICATION

(11) **EP 2 608 259 A2**
(43) Date of publication of application: **26.06.2013**
(21) Application number: 12197405.9
(22) Date of filing: 17.12.2012
(51) Int. Cl.: H01L 23/467

(54) **Cooling device and electronic apparatus using same**

(30) Priority: 19.12.2011 JP 2011277031
(71) Applicant: NEC Network Products, Ltd., Fukushima (JP)
(72) Inventor: Sasaki, Manabu, Fukushima (JP)
(74) Representative: Betten & Resch

(57) **Abstract**

To improve a local cooling effect even when the rearrangement of devices is very difficult. A cooling device 1 includes a heat sink 11 disposed on a heat-generating element 2 disposed inside a housing, a heat-radiating plate 12 that thermally connects the heat sink 11 with the housing, a special-purpose duct 13 that guides cooling air directly to the heat-generating element 2, and a special-purpose fan 14 that sends out the cooling air into the special-purpose duct 13. The heat-radiating plate 12 is a leaf-spring-like component, and is in contact with the upper surface section of the heat sink 11 and the internal surface section of the housing with predetermined elasticity.

## Description

### INCORPORATION BY REFERENCE

This application is based upon and claims the benefit of priority from Japanese patent application No. 2011-277031, filed on December 19, 2011, the disclosure of which is incorporated herein in its entirety by reference.

### BACKGROUND OF THE INVENTION

### 1. Technical Field

The present invention relates to a device for cooling a heat-generating element such as an integrated circuit disposed inside the housing of an electronic apparatus such as a computer and a communication apparatus.

### 2. Background Art

In various electronic apparatuses such as a computer, a cooling device for cooling an electronic device such as a CPU, a HDD, and a memory is used.

Japanese Unexamined Patent Application Publication No. 09-8484 discloses a cooling mechanism for an electronic apparatus, in which in order to improve a local cooling effect, a duct having an intake port and a duct cover covering the duct are provided on the component-mounting surface of a circuit board, and air flowing through the intake port thereby flows above a heat-generating component(s) in a concentrated manner.

Further, Japanese Unexamined Patent Application Publications No. 2006-049388, No. 2004-111655 and No. 06-104586, and Japanese Unexamined Utility Model Application Publication No. 05-038984 disclose other techniques related to the technical field of the present invention.

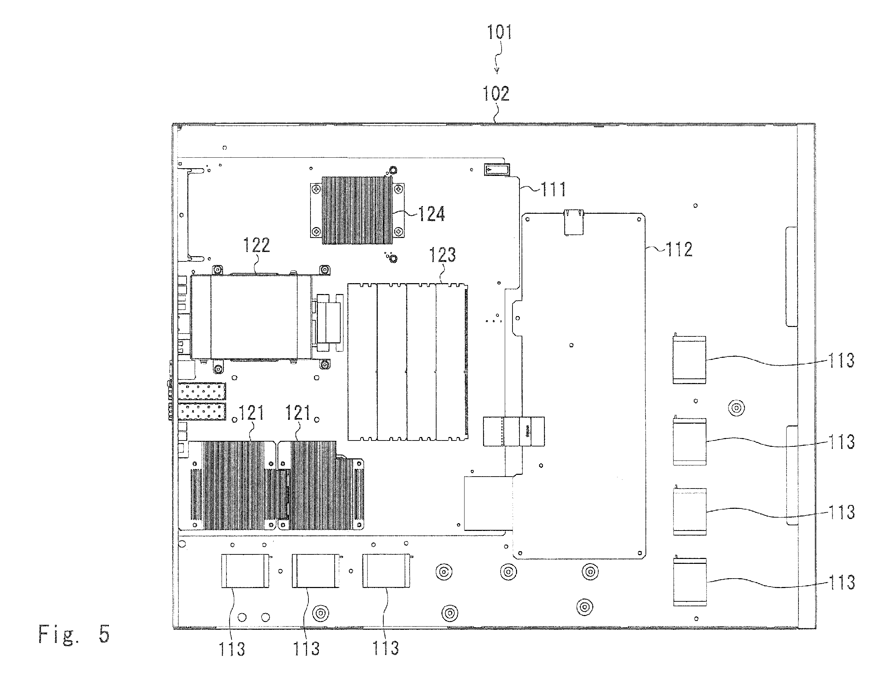

Fig. 5 is a diagram for explaining problems in a related-art cooling device. In the figure, the internal configuration of a housing 102 of an electronic apparatus 101 is shown. Within the housing 102, a printed-circuit board for control circuit 111, a printed-circuit board for power-supply 112, and a plurality of fans 113 are disposed. In the printed-circuit board for control circuit 111, a main CPU 121, a HDD 122, a memory board 123, and an electronic device 124 having a specific function are mounted. The main CPU 121, the HDD 122, the memory board 123, and the electronic device 124 generate heat when they are driven, and they are cooled by cooling air produced by the fans 113.

In the above-described example, since the electronic device 124 is located in a place far away from the fans 113 and surrounded by the other devices 121, 122 and 123, the cooling air produced by the fans 113 can hardly reach the electronic device 124. As a result, a sufficient cooling effect can be hardly achieved. It is conceivable that the problem like this can be solved by the rearrangement of those devices including the electronic device 124 and the fans 113. However, due to constraints such as the reduction in the apparatus size and the increase in the heat generated by each device in recent years, it is becoming very difficult to attain the solution like this.

### SUMMARY

An exemplary object of the invention is to improve a local cooling effect even when the rearrangement of devices is very difficult.

In a first exemplary aspect of the invention, a cooling device includes: a heat sink disposed on a heat-generating element disposed inside a housing; a heat-radiating component that thermally connects the heat sink with the housing; a special-purpose duct that guides cooling air directly to the heat-generating element; and a special-purpose fan that sends out the cooling air into the special-purpose duct.

Further, a second exemplary aspect of the invention is an electronic apparatus including a cooling device that cools a plurality of heat-generating elements disposed inside a housing, in which the cooling device includes: a heat sink disposed on a specific heat-generating element selected from the plurality of heat-generating elements; a heat-radiating component that thermally connects the heat sink with the housing; a special-purpose duct that guides cooling air directly to the specific heat-generating element; and a special-purpose fan that sends out the cooling air into the special-purpose duct.

### BRIEF DESCRIPTION OF THE DRAWINGS

The above and other aspects, features, and advantages of the present invention will become more apparent from the following description of certain exemplary embodiments when taken in conjunction with the accompanying drawings, in which:
Fig. 1 shows a structure of a cooling device of a cooling device according to a first exemplary embodiment of the present invention;
Fig. 2 is a cross section taken along the line II-II in Fig. 1, showing a structure of a heat-radiating plate according to a first exemplary embodiment of the present invention;
Fig. 3 is a plane view showing a configuration of an electronic apparatus including a cooling device according to a first exemplary embodiment of the present invention;
Fig. 4 is a perspective view showing a configuration of an electronic apparatus including a cooling device according to a first exemplary embodiment of the present invention; and
Fig. 5 is a diagram for explaining problems of a related-art cooling device.

### EXEMPLARY EMBODIMENT

### [First exemplary embodiment]

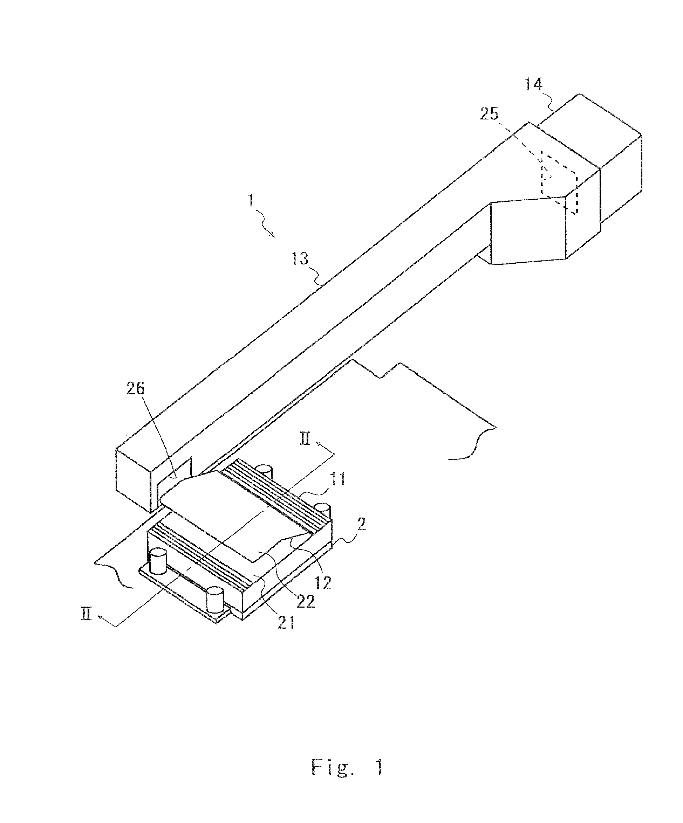

Exemplary embodiments according to the present invention are explained hereinafter with reference to the drawings. Fig. 1 shows a structure of a cooling device 1 according to a first exemplary embodiment of the present invention. The cooling device 1 is disposed inside an electronic apparatus such as a computer and a communication apparatus, and is used to air-cool an electronic device 2 (heat-generating element) such as a CPU, disposed inside the housing of the electronic apparatus. The cooling device 1 includes a heat sink 11, a heat-radiating plate 12, a special-purpose duct 13, and a special-purpose fan 14.

The heat sink 11 is made of material having high heat-conductivity such as aluminum and copper, and includes a plurality of fins in order to increase the contact area with cooling air. The heat sink 11 is in contact with and fixed on the upper surface of the electronic device 2. The electronic device 2 is a specific device selected from a plurality of electronic devices disposed inside the housing. The heat sink 11 facilitates the cooling process for the electronic device 2 by heat exchange with cooling air through the fins.

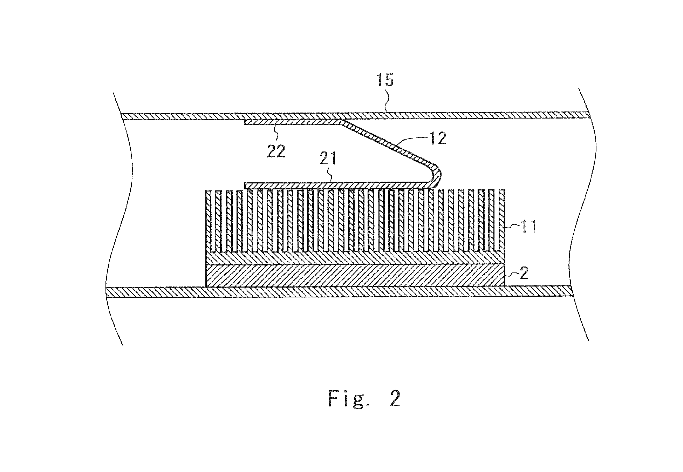

The heat-radiating plate 12 is made of material having high heat-conductivity and elasticity, and is a leaf-spring-like component having roughly a U-shape or V-shape in cross section. Fig. 2 shows a structure of the heat-radiating plate 12. The lower surface section 21 of the heat-radiating plate 12 is fixed on the upper surface section of the heat sink 11, and the upper surface section 22 of the heat-radiating plate 12 is in contact with the internal surface section of the housing 15 of the electronic apparatus. The heat-radiating plate 12 thermally connects the heat sink 11 with the housing 15, and thereby facilitates the cooling process for the electronic device 2 even further.

The special-purpose duct 13 (see Fig. 1) is a hollow component and has an inflow port 25 and an outflow port 26. The inflow port 25 opens toward the special-purpose fan 14 (which is explained later). The outflow port 26 opens toward the electronic device 2 and the heat sink 11. The special-purpose duct 13 is a duct that is provided exclusively for guiding cooling air directly to the above-described electronic device 2.

The special-purpose fan 14 is driven by an electric motor or the like and thereby generates cooling air. The cooling air flows into the inflow port 25 of the special-purpose duct 13 and flows out from the outflow port 26. The special-purpose fan 14 is a fan that is provided exclusively for sending out cooling air into the special-purpose duct.

With the above-described configuration, the electronic device 2 is sufficiently cooled by using both the heat-transfer scheme using the heat sink 11 and the heat-radiating plate 12, and the local air-blowing scheme using the special-purpose duct 13 and the special-purpose fan 14.

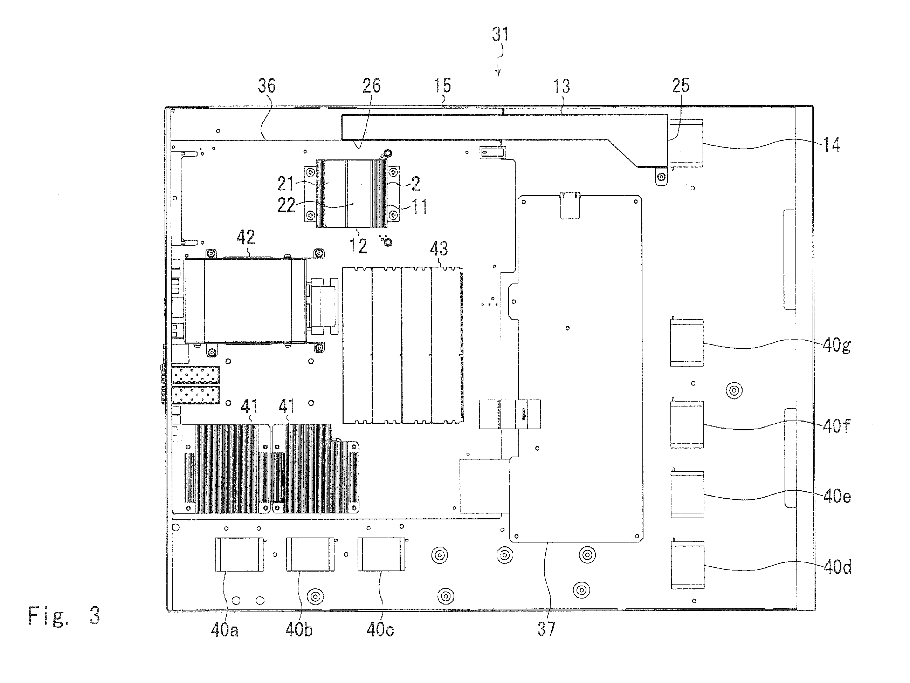

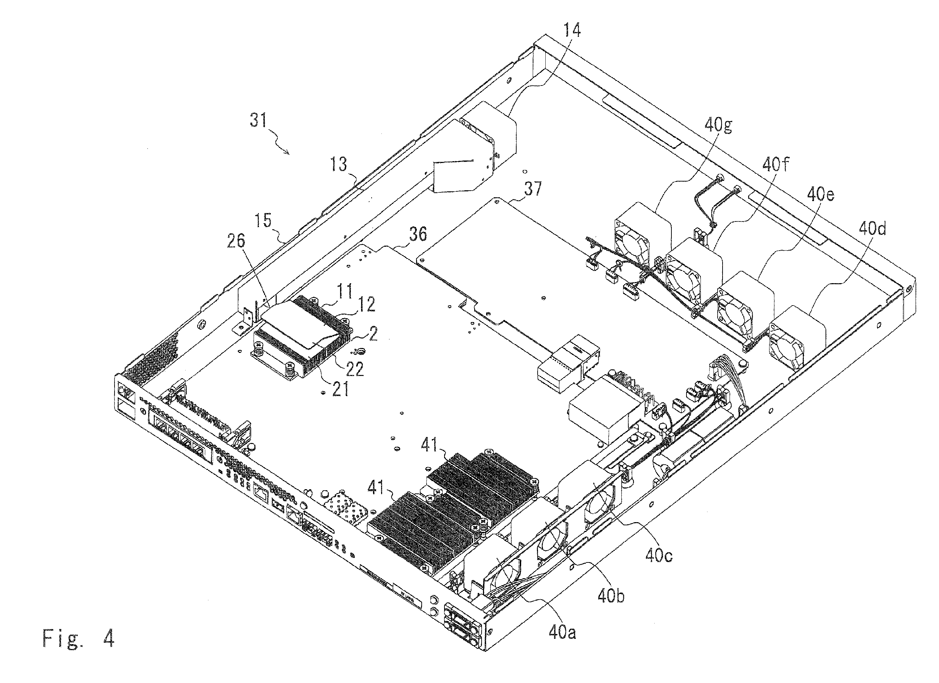

Fig. 3 is a plane view showing the internal configuration of an electronic apparatus 31 including the above-described cooling device 1. Fig. 4 is a perspective view showing the same internal configuration (illustration of the HDD 42 and the memory board 43 is omitted).

Within the housing 15, a printed-circuit board for control circuit 36 and a printed-circuit board for power-supply 37 are disposed. A plurality of fans 40a, 40b, 40c, 40d, 40e, 40f and 40g, and the above-described special-purpose fan 14 are disposed on the periphery of both the boards 36 and 37. The fans 40a to 40f send air toward both boards 36 and 37 and thereby cool devices mounted on both boards 36 and 37.

The fans 40d, 40e, 40f and 40g send air toward the printed-circuit board for control circuit 36 and the printed-circuit board for power-supply 37. The fans 40a, 40b and 40c send air intensively toward the main CPU 41, the HDD 42, and the memory board 43, each of which generates relatively large heat among the devices located inside the housing 15.

The special-purpose fan 14 is used to send out cooling air to exclusively cool the electronic device 2. The electronic device 2 according to this exemplary embodiment is located in a place further away from the fans 40a to 40g in comparison to the places of the other devices. Further, the electronic device 2 is located on the downstream side of the main CPU 41, which generates especially large heat, in the flow direction of the cooling air sent out by the fans 40a to 40c. Further, the electronic device 2 is located on the downstream side of the HDD 42 and the memory board 43 whose heights are high.

The special-purpose duct 13 is disposed in such a manner that its inflow port 25 faces the special-purpose fan 14 and its outflow port 26 faces the electronic device 2. The heat sink 11 is fixed on the upper surface section of the electronic device 2. The heat-radiating plate 12 is fixed on the upper surface section of the heat sink 11. The lower surface section 21 of the heat-radiating plate 12 is fixed to the heat sink 11, and the upper surface section 22 of the heat-radiating plate 12 is in contact with the top plate of the housing 15.

The cooling action for the above-described electronic apparatus 31 is explained hereinafter. Upon the start of the operation of the electronic apparatus 31, the fans 40a to 40g and the special-purpose fan 14 are driven. As a result, an air-blowing process for each device mounted on the printed-circuit board for control circuit 36 and the printed-circuit board for power-supply 37 starts.

In this exemplary embodiment, the devices for which cooling is especially necessary include the CPU 41, the HDD 42, the memory board 43, and the electronic device 2. Among them, the CPU 41, the HDD 42, and the memory board 43 are sufficiently cooled by the fans 40a to 40c located in the vicinity of these devices.

However, as for the electronic device 2, the sufficient cooling effect cannot be obtained by these fans 40a to 40c. This is because the electronic device 2 is located in a place far away from the fans 40d to 40g and cooling air is not sufficiently supplied to the electronic device 2 by these fans 40d to 40g. Further, the electronic device 2 is located on the downstream side of the CPU 41, the HDD 42, and the memory board 43 in the flow direction of the cooling air produced by the fans 40a to 40c. Therefore, the temperature of the cooling air becomes higher when it reaches the electronic device 2 and the amount of the cooling air reaching the electronic device 2 is small due to the physical obstacle caused by these devices.

However, the electronic device 2 is sufficiently cooled by the cooling air sent out by the special-purpose fan 14. This is because the cooling air produced by the special-purpose fan 14 passes through the special-purpose duct 13 and is directly blown to the electronic device 2 and the heat sink 11. Further, since the heat sink 11 is thermally connected to the housing 15 through the heat-radiating plate 12, the heat dissipating process for the electronic device 2 is accelerated. The heat-radiating plate 12 is a leaf-spring-like component. Therefore, when the removable top plate is fixed to the housing 15, the heat-radiating plate 12 is pressed by the top plate and thereby reliably brought into contact with the top plate.

As described above, according to this exemplary embodiment of the present invention, the electronic device 2 is sufficiently cooled by using both the heat-transfer scheme using the heat sink 11 and the heat-radiating plate 12, and the local air-blowing scheme using the special-purpose duct 13 and the special-purpose fan 14. As a result, it is possible to sufficiently cool the specific electronic device 2 even when the rearrangement of the devices located inside the housing 15 is very difficult. Further, the present invention is also suitable, for example, for the cases where the heat generated by the electronic device 2 is especially large.

Note that the present invention is not limited to the above-described exemplary embodiments, and they can be modified as desired without departing from the spirit and scope of the present invention.

An exemplary advantage according to the above-described embodiments is that, a specific device is cooled by using both a heat-transfer scheme using a heat sink and a heat-radiating component, and a local air-blowing scheme using a special-purpose duct and a special purpose fan. As a result, even when the rearrangement of devices is impossible, it is possible to sufficiently cool the specific device.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

## Claims

1. A cooling device comprising:
a heat sink disposed on a heat-generating element disposed inside a housing;
a heat-radiating component that thermally connects the heat sink with the housing;
a special-purpose duct that guides cooling air directly to the heat-generating element; and
a special-purpose fan that sends out the cooling air into the special-purpose duct.

2. The cooling device according to Claim 1, wherein the heat-radiating component is a leaf-spring-like component, and is in contact with an upper surface section of the heat sink and an internal surface section of the housing with predetermined elasticity.

3. An electronic apparatus comprising a cooling device that cools a plurality of heat-generating elements disposed inside a housing, wherein the cooling device comprises:
a heat sink disposed on a specific heat-generating element selected from the plurality of heat-generating elements;
a heat-radiating component that thermally connects the heat sink with the housing;
a special-purpose duct that guides cooling air directly to the specific heat-generating element; and
a special-purpose fan that sends out the cooling air into the special-purpose duct.

4. The electronic apparatus according to Claim 3, wherein the specific heat-generating element is located on a downstream side of a main CPU in a flow direction of cooling air for cooling the main CPU.

5. The electronic apparatus according to Claim 3 or 4, wherein the specific heat-generating element is located on a downstream side of an HDD or a memory board in a flow direction of cooling air for cooling the HDD or the memory board.
